# EUROPÄISCHE PATENTSCHRIFT

(11) **EP 0 997 928 B1**
(45) Veröffentlichungstag und Bekanntmachung des Hinweises auf die Patenterteilung: **28.11.2007**
(21) Anmeldenummer: 99120871.1
(22) Anmeldetag: 27.10.1999
(51) Int. Cl.: H01L 21/02, H01L 29/92, H01L 27/115, C23C 16/40

(54) **Verfahren zur Herstellung eines Kondensators**
Process for fabricating a capacitor
Procédé de fabrication d'un condensateur

(30) Priorität: 27.10.1998 DE 19849542
(43) Veröffentlichungstag der Anmeldung: 03.05.2000
(73) Patentinhaber: Qimonda AG, 81739 München (DE)
(72) Erfinder: Beitel, Gerhard, Dr., 80335 München (DE); Fritsch, Elke, Dr., 81737 München (DE); Wendt, Hermann, Dr., 85630 Grasbrunn (DE)
(74) Vertreter: Müller - Hoffmann & Partner

(56) Entgegenhaltungen:
- DE-A- 19 852 256
- US-A- 5 335 138
- US-A- 5 559 666
- US-A- 5 621 606
- LEE W -J ET AL: "Ir and Ru bottom electrodes for (Ba, Sr)TiO3 thin films deposited by liquid delivery source chemical vapor deposition" PREPARATION AND CHARACTERIZATION,NL,ELSEVIER SEQUOIA, Bd. 323, Nr. 1-2, Juni 1998 (1998-06), Seite 285-290 XP004147981 ISSN: 0040-6090

## Beschreibung

Die vorliegende Erfindung liegt auf dem Gebiet der Halbleitertechnik und betrifft ein Verfahren zur Herstellung eines Kondensators gemäß Oberbegriff des Anspruchs 1.

Zur weiteren Erhöhung der Integrationsdichte bei Halbleiterspeicherbausteinen werden zukünftig in verstärktem Maße Materialien mit einer hohen Dielektrizitätskonstante bzw. mit ferroelektrischen Eigenschaften verwendet. Durch Einsatz dieser Materialien erhofft man sich eine höhere Speicherdichte (Ladung/Fläche) gegenüber den bisher verwendeten Kondensatordielektrika (Oxid/Nitrid/Oxid). Ein bevorzugtes Material mit hoher Dielektrizitätskonstante ist beispielsweise Barium-Strontium-Titanat (BST). Als ferroelektrische Materialien sollen hier beispielhaft Strontium-Bismut-Tantalat (SBT) sowie Blei-Zircon-Titanat (PZT) aufgeführt werden.

Die Prozeßintegration dieser Materialien zieht jedoch eine Reihe von Problemen nach sich. Besondere Schwierigkeiten bereitet die Abscheidung. Die als Kondensatordielektrikum verwendeten Materialien (Metalloxidschichten in keramischer Form) lassen sich beispielsweise mit CVD-Abscheideprozessen konform auf eine Halbleiteroberfläche aufbringen. Dabei werden diese Metalloxidschichten unter anderem unmittelbar auf eine erste Elektrode eines Speicherkondensators aufgebracht. Das für diese Elektrode verwendete Material muß sauerstoffresistent sein, da die Abscheidung der Metalloxidschicht in einer oxidierenden Atmosphäre erfolgt. Als geeignete Elektrodenmaterialien haben sich unter anderem Platin und Ruthenium erwiesen. Ein Nachteil dieser Materialien ist jedoch, daß sie eine hohe Diffusion in Silizium aufweisen bzw. mit Silizium Metallsilizidschichten bilden, die die Funktionsweise von aktiven Bauelementen irreversibel beeinflussen können. Daher wird üblicherweise unterhalb der Elektrodenmaterialien eine sogenannte Barrierenschicht angeordnet, die eine Diffusion der Elektrodenmaterialien in das darunter liegende Silizium verhindert. Derartige Barrierenschichten bestehen beispielsweise aus einer Titan/Titannitrid-Kombination.

Ungünstigerweise sind jedoch diese Barrierenschichten oxidationsempfindlich und können bei der CVD-Abscheidung der Metalloxidschichten leicht oxidieren. Insbesondere bei der Verwendung von Titan als Bestandteil der Barrierenschicht besteht daher die Gefahr, daß die üblicherweise leitfähige Barrierenschicht durch die Oxidation isolierend wird. Die Kontaktierung der ersten (unteren) Elektrode des Speicherkondensators ist somit nicht mehr möglich.

Um die Oxidation der Barrierenschicht während der CVD-Abscheidung zu verhindern, wird beispielsweise in der EP 0 739 030 A2 die Bildung von seitlichen Isolationsstegen um die strukturierte Barrierenschicht herum vorgeschlagen. Die aus Siliziumnitrid bestehenden Isolationsstege werden nach dem gemeinsamen Ätzen der unteren Elektrode sowie der Barrierenschicht durch konforme Abscheidung einer Siliziumnitridschicht und deren anisotrope Ätzung gebildet. Im wesentlichen verbleibt dabei die Siliziumnitridschicht im unteren Bereich der Elektrode, d.h. nur im Bereich der Barrierenschicht.

Seitliche Isolationsstege um die Barrierenschicht herum werden auch in der US 5,656,852 vorgeschlagen. Die Isolationsstege, die aus Siliziumdioxid oder Siliziumnitrid bestehen können, werden dort vor der Abscheidung der unteren Metallelektrode gebildet.

Allen vorbekannten Isolationsstegen gemein ist deren Bildung aus einer konform abgeschiedenen Isolationsschicht mit nachfolgendem anisotropen Ätzen. Dabei kann es insbesondere durch den notwendigen Ätzschritt zu einem Angriff der Barrierenschicht bzw. der Elektrode kommen oder eine dieser beiden Schichten durch die Isolationsschicht verunreinigt werden.

Insbesondere ist die Verunreinigung der Metallelektrode nachteilhaft, da die Materialeigenschaften der auf die Metallelektrode aufzubringenden Metalloxidschicht in hohem Maße von der Grenzflächengüte zwischen Metallelektrode und Metalloxidschicht abhängt.

Im Gegensatz dazu ist aus der US 5,554,866 bekannt, seitliche Passienierungsrandstege durch teilweise Oxidation einer sauerstoffempfindlichen Barriereschicht zu schaffen. Dabei wird die Barriereschicht vor Abscheidung der Metalloxidschicht in ihren Randbereichen oxidiert. Die dort entstehenden Passivierungsrandstege sollen bei der nachfolgenden Abscheidung der Metalloxidschicht als Sauerstoffbarriere dienen. Nachteilig bei diesem Verfahren ist die starke Volumenzunahme durch die Aufnahme von Sauerstoff und die damit verbundene schlechte Haftung der oberhalb der Barriereschicht befindlichen Elektrodenschicht.

Es ist daher Aufgabe der Erfindung, ein Verfahren zu benennen, das die Haftung der Elektrodenschicht gewährleistet und das technologisch einfach zu realisieren ist.

Diese Aufgabe wird bei einem eingangs genannten Verfahren zur Herstellung eines Kondensators erfindungsgemäß dadurch gelöst, daß die siliziumhaltige Oxidschicht oder die Siliziumnitridschicht beim bereichsweisen Ätzen oder durch einen zusätzlichen Ätzschritt bis zu einem vorbestimmten Grad angegriffen wird, wobei Ätzreste der siliziumhaltigen Oxidschicht oder der Siliziumnitridschicht zumindest im Randbereich der Barrierenschicht verbleiben und dort während der CVD-Abscheidung der Metalloxidschicht zusammen mit Bestandteilen der Metalloxidschicht in situ einen im wesentlichen amorphen Passivierungsrandstegs zwischen der Metalloxidschicht und der Barrierenschicht bilden.

Die Erfindung geht von der Erkenntnis aus, daß sich bei geeigneter Wahl der Prozeßparameter, insbesondere hinsichtlich des Ätzvorganges und der CVD-Abscheidung, ein selbstjustierter Passivierungsrandsteg um die Barrierenschichten herum herausbildet. Dazu ist es einerseits notwendig, daß beim Ätzen der Elektrode und der Barrierenschicht bzw. bei einem zusätzlichen Ätzschritt die unter der Barrierenschicht befindliche Oxidschicht bis zu einem bestimmten Grade angegriffen wird. Dieses Anätzen der Oxidschicht führt zu einem gewissen Materialabtrag der Oxidschicht seitlich der bereits geätzten Elektrode und der Barrierenschicht. Dabei wird ein Teil des abgetragenen Materials an den Seitenwänden der Barrierenschicht sowie der Elektrodenschicht redeponiert. Bei dem nachfolgenden Abscheiden der Metalloxidschicht aus einer CVD-Gasphase bildet sich aus dem dort redeponierten Material ein armorpher Passivierungsrandsteg, der die Barrierenschicht während der weiteren CVD-Abscheidung vor einer Oxidation schützt. Da sich dieser Passivierungsrandsteg während der CVD-Abscheidung herausbildet, ist es möglich, daß die Barrierenschicht bis zu einem gewissen Grade an ihren Rändern oxidiert wird. Durch den sich relativ schnell herausbildenden Passivierungsrandsteg wird jedoch mit dessen zunehmender Ausbildung eine fortschreitende Oxidation der Barrierenschicht gehemmt, so daß von einer selbsthemmenden Oxidationsbarriere gesprochen werden kann.

Mit weiter fortschreitender Abscheidung der Metalloxidschicht verlangsamt sich auch die weitere Bildung des Passivierungsrandstegs. Dies hat zum einen seinen Grund darin, daß nur eine begrenzte Menge der abgeschiedenen Metalloxide vom redeponierten Material aufgenommen werden kann. Ein anderer Grund ist in der zunehmenden Bedeckung des redeponierten Materials mit den abgeschiedenen Metalloxiden zu suchen. Grundsätzlich weist der entstandene Passivierungsrandsteg eine gewisse Materialstärke in Abhängigkeit von der Menge des redeponierten Materials und den gewählten Prozeßbedingungen auf.

Zur Bildung des Passivierungsrandstegs trägt neben dem deponierten Material andererseits auch die Gasphase selbst bei. Die abgeschiedenen Metalle bzw. Metalloxide dringen während der CVD-Abscheidung bis zu einem gewissen Grade in das redeponierte Material, eventuell auch in die Barrierenschicht, ein und bilden dort ein amorphes Mischoxid. Dieses Mischoxid weist somit Bestandteile der Barriere, der siliziumhaltigen Oxidschicht sowie der abgeschiedenen Metalloxidschicht auf.

Die Schichtdicke und Ausdehnung des Passivierungsrandstegs kann neben der Variation der Ätztiefe in der siliziumhaltigen Oxidschicht auch durch Veränderung der Steilheit der Ätzflanken sowie der Abscheidetemperatur der CVD-Abscheidung kontrolliert werden. Bei typischen Prozeßparametern ist der Passivierungsrandsteg etwa doppelt so dick wie die abgeschiedene Metalloxidschicht. Soll der Passivierungsrandsteg dicker ausgebildet werden, so empfiehlt sich ein stärkeres Anätzen der siliziumhaltigen Oxidschicht. Umgekehrt kann neben einer verringerten Ätztiefe auch eine geringere Abscheidetemperatur zur Reduzierung der Dicke des Passivierungsrandstegs angestrebt werden.

Durch das erfindungsgemäße Verfahren kann auf separat hergestellte Isolationsrandstege verzichtet werden. Dadurch verringert sich einerseits die Prozeßschrittzahl und andererseits wird ein unerwünschtes Verunreinigen der unteren Elektrode ausgeschlossen. Weiterhin wird eine einfache Kontrolle der Ausdehnung des Passivierungsrandstegs ermöglicht. Beispielsweise ist es möglich, die Bildung des Passivierungsrandstegs auf den Bereich seitlich der Barrierenschicht zu begrenzen, so daß die Seitenflanken der über der Barrierenschicht angeordneten Elektrode nicht vom Passivierungsrandsteg bedeckt sind und als effektive Kondensatorfläche zur Speicherung von Ladung zur Verfügung stehen.

Auch ist das Bedecken der Elektrode mit dem Passivierungsrandsteg nicht unbedingt notwendig, da die Elektrode die Barrierenschicht während der CVD-Abscheidung in oxidierender Atmosphäre von oben in ausreichendem Maße schützt.

Da sich die Bildung des Passivierungsrandstegs im wesentlichen auf die äußeren Randbereiche der Barrierenschicht begrenzt ist, wird eine ausreichende Haftung der Elektrode auf der Barrierenschicht gewährleistet. Der Passivierungsrandsteg bildet sich im wesentlichen nur dort, wo Material abgelagert wird. Dadurch wird die Barrierenschicht durch einen, wenngleich noch nicht vollständig ausgebildeten Passivierungsrandsteg bereits vor der CVD-Abscheidung geschützt.

Bevorzugt wird als siliziumhaltige Oxidschicht eine TEOS-Schicht oder eine Siliziumnitridschicht verwendet. Es hat sich gezeigt, daß sich die unter Verwendung dieser Schichten herausbildenden Passivierungsrandstege als besonders effektive Oxidationsbarriere erweisen.

Bevorzugt wird die Elektrodenschicht und die Barrierenschicht mittels reaktivem Ionenätzen unter Anwesenheit von Chlor geätzt. Dies kann in zwei separaten Prozeßschritten, bevorzugt jedoch in einem erfolgen. Je nach Dauer des Ätzvorgangs und der damit einhergehenden Ätztiefe in der siliziumhaltigen Oxidschicht sollte die Abscheidetemperatur während der CVD-Abscheidung entsprechend angepaßt werden, damit der Passivierungsrandsteg die gewünschte Stärke aufweist.

Besonders effektiv ist die Wirkung des Passivierungsrandstegs bei der Abscheidung der Metalloxidschicht aus einem Gemisch von Erd- und Erdallkalimetallkomplexen, die Beta-Diketonate enthalten. Derartige Metallkomplexe liegen bei der gewählten Abscheidetemperatur als flüchtige Substanzen vor und verteilen sich somit gleichmäßig über die gesamte Oberfläche des zu prozessierenden Substrats. Daher gelangen diese Metallkomplexe auch an die Seitenwände der Barrierenschicht und somit zu dem dort redeponierten Material. Auch weisen insbesondere die Beta-Diketonatkomplexe eine gewisse Reaktionsfreudigkeit hinsichtlich des redeponierten Materials auf.

Besonders bevorzugt ist die Abscheidung einer Metalloxidschicht in Form einer Barium-Strontium-Titanat-Schicht (BST) oder Strontium-Bismut-Tantalat-Schicht (SBT). Die dabei bevorzugte Abscheidetemperatur liegt etwa zwischen 400°C und 600°C. Der sich während der CVD-Abscheidung herausbildende Passivierungsrandsteg besteht daher überwiegend aus Titanoxid oder Tantaloxid mit Anteilen von Silizium, Kohlenstoff, Barium, Bismut und Strontium. Charakteristisch dabei ist, daß der Anteil von Barium und Strontium im Passivierungsrandsteg etwa nur halb so hoch wie beispielsweise in der Barium-Strontium-Titanat-Schicht ist. Die chemische Zusammensetzung des Passivierungsrandstegs kann auch durch Variation der Stöchiometrie während der CVD-Abscheidung eingestellt werden. Die abgeschiedene Metalloxidschicht haftet weiterhin ausreichend auf dem Passivierungsrandsteg.

Weiterhin wird bevorzugt, daß nach der Abscheidung der Metalloxidschicht zumindest eine weitere Elektrode auf die Metalloxidschicht aufgebracht wird. Dies kann unter anderem durch ganzflächige Abscheidung eines Metalls mit anschließendem Strukturieren erfolgen. Sofern die Metalloxidschicht noch nicht die gewünschte polykristalline Struktur aufweist, kann diese vor oder nach Abscheidung der weiteren Elektrode einem thermischen Ausheilschritt unterworfen werden. Dadurch verändert sich das polykristalline Gefüge der Metalloxidschicht und damit die dielektrischen Eigenschaften der Metalloxidschicht. Während des Ausheilschritts wird der Passivierungsrandsteg nicht verändert.

Der erfindungsgemäß gebildete Passivierungsrandsteg ist nicht bloß eine unmittelbare Übergangsschicht zwischen Barrierenschicht und Metalloxidschicht, sondern eine von beiden wohl unterscheidbare Zwischenschicht mit eigener Struktur. Dies konnte sowohl in rasterelektronenmikroskopischen und anderen Strukturuntersuchungen nachgewiesen werden.

Im folgenden wird die Erfindung anhand eines Beispiels näher erläutert und in Figuren dargestellt. Es zeigen:
- Figuren 1 bis 3: die einzelnen Verfahrensschritte zur Herstellung eines Passivierungsrandstegs,
- Figur 4: ein vergrößerter Ausschnitt des Randbereichs einer Barrierenschicht und
- Figur 5: eine Speicherzelle einer Halbleiterspeichervorrichtung mit Passivierungsrandstegen an den Seitenbereichen des Speicherkondensators.

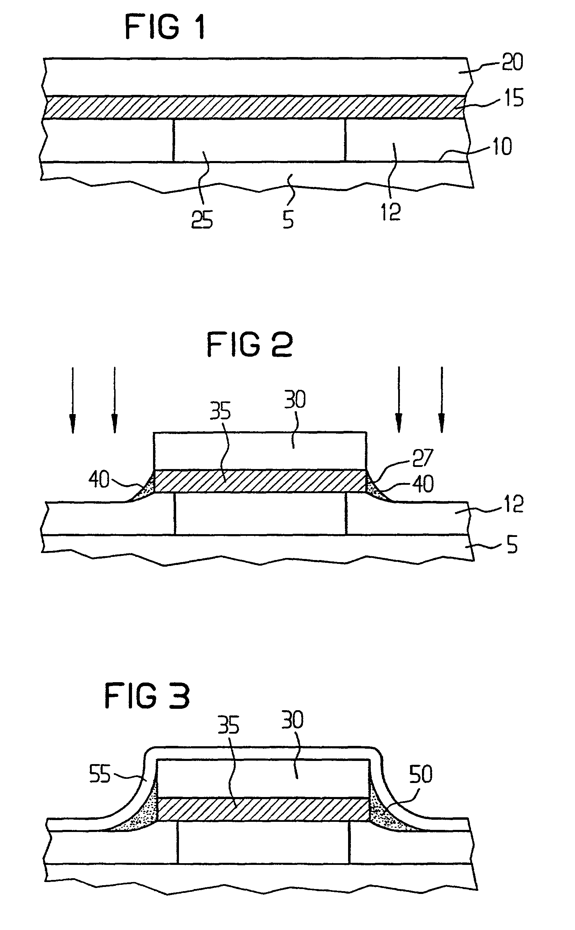

Figur 1 zeigt ein Substrat 5, auf dessen Oberfläche 10 eine siliziumhaltige Oxidschicht 12, eine Barrierenschicht 15 sowie eine Elektrodenschicht 20 angeordnet sind. Die Barrierenschicht 15 besteht aus einer Titannitrid-Titan-Kombination, die Elektrodenschicht 20 hingegen aus Platin oder einem anderen wenig reaktivem Metall. Bevorzugt wird eine TEOS-Schicht 12 (Tetraethylorthosilikat) als siliziumhaltige Oxidschicht 12 verwendet. In dieser ist weiterhin ein mit Polysilizium gefülltes Kontaktloch 25 angeordnet. Dieses stellt die leitende Verbindung zwischen der Elektrodenschicht 20 und einem hier nicht näher dargestellten aktiven Bauelement her. Zwischen der Elektrodenschicht 20 und dem mit Polysilizium gefüllten Kontaktloch 25 befindet sich die Barrierenschicht 15 zur Verhinderung der Platindiffusion ins Silizium bzw. der Siliziumdiffusion ins Platin. Die als Barrierenschicht 15 dienende Titan und Titannitridschichtkombination wurde durch Sputterabscheidung aufgetragen, wobei die Titanschicht etwa 20 nm und die Titannitridschicht etwa 100 nm dick ist. Die Elektrodenschicht 20 wurde ebenfalls durch eine Sputterabscheidung bei einer Temperatur zwischen 450°C und 550°C mit einer Dicke von 100 nm geschaffen.

Die in Figur 1 dargestellte Struktur wird nachfolgend einem Ätzprozeß unterworfen. Dazu wird zunächst eine geeignete Maske, beispielsweise eine Photolackschicht, aufgebracht und strukturiert. Danach werden die Elektrodenschicht 20 und die Barrierenschicht 15 mittels reaktivem Ionenätzen unter Anwesenheit eines Chlorplasmas geätzt, wobei die Ätzung bis zur TEOS-Schicht 12 und bis zur einem Grade in diese hinein durchgeführt wird. Dabei entstehen zumindest im Randbereich 27 der entstandenen Barriere 35 und teilweise im Randbereich der darüber befindlichen Platinelektrode 30 Materialablagerungen 40, die im wesentlichen durch redeponiertes TEOS-Material gebildet werden. Die so entstandene Struktur ist in Figur 2 dargestellt. Andere Ätzverfahren, beispielsweise unter Verwendung von Argon, können auch verwendet werden. Insbesondere beim Ätzen mit Argon entstehen relativ steile Flanken.

Beim Ätzen der TEOS-Schicht 12 wurde die Erkenntnis ausgenutzt, daß redeponiertes Material an Seitenflanken erhabener Strukturen teilweise durch den Ätzprozeß wieder abgetragen werden, und so die Seitenflanken der Strukturen nicht vollständig von dem redeponierten Material überdeckt werden. Dadurch bilden sich die Materialablagerungen 40 im wesentlichen im unteren Bereich der Platinelektrode 30 sowie vollständig im Bereich der Barriere 35 aus, d.h., daß seitlich der geätzten Barriere 35 die Materialablagerungen 40 entstehen.

Nach dem Ätzen der Elektrodenschicht 20 sowie der Barrierenschicht 12 erfolgt die Barium-Strontium-Titanat-Abscheidung mittels eines CVD-Prozesses. Dazu wird das Substrat 5 in einen geeigneten CVD-Reaktor eingebracht und diesem Ausgangsprodukte in Form von Diketonatkomplexen zugeführt. Im einzeln werden Ba(thd)₃(tetraglyme), Sr(thd)₃(tetraglyme) sowie Ti(O-iPr)₃ verwendet, wobei thd für 2,2,6,6-Tetramethylheptan-3,5-dionat, Tetraglyme für Tetraethylenglykoldimethylether und O-iPr für Isopropoxid steht. Thd ist ein häufig verwendetes Beta-Diketonat, das sich in hervorragender Weise zur CVD-Abscheidung von Erdalkalimetallen eignet. Häufig sind diese Beta-Diketonatkomplexe mit Tetraglyme stabilisiert. Die Ausgangsstoffe sind in Butylacetat gelöst und werden in einem speziellen Verdampfer bei einer Temperatur von etwa 245 °C verdampft. Als Trägergas wird Argon verwendet. Die so verdampften Ausgangsstoffe werden in sogenannten Showerheads des CVD-Reaktors mit den oxidierenden Gasen Sauerstoff und N₂O vermischt.

Die BST-Abscheidung erfolgt bei einer Temperatur von etwa 580°C, wobei ein Abscheidedruck von etwa 100 Pa herrscht. Als Gasflüsse werden für Sauerstoff etwa 500 sccm, für N₂O etwa 500 sccm und für Argon etwa 200 sccm eingestellt, so daß etwa 0,1 ml der in Butylacetat gelösten Ausgangsstoffe pro Minute verdampft wird. Bei den vorgenannten Prozeßbedingungen bildet sich eine etwa 25 nm dicke BST-Schicht 55 innerhalb von 200 Sekunden heraus. Charakteristisch für diese BST-Schicht ist ein etwa 51 %iger Gewichtsanteil an Titan und ein Barium-Strontium-Verhältnis von 70 zu 30.

Während der BST-Abscheidung wird insbesondere zu Beginn der Abscheidung der amorphe Passivierungsrandsteg 50 gebildet. Dies erfolgt im wesentlichen durch Reaktion der BST-Ausgangsprodukte mit dem redeponierten Material 40. Der Passivierungsrandsteg 50, der sich seitlich zwischen der Barriere 35 und der BST-Schicht 55 bildet, verhindert eine Oxidation der Barriere 35. Der gebildete Passivierungsrandsteg 50 ist mit circa 50 nm etwa doppelt so dick wie die BST-Schicht 55 und im wesentlichen amorph mit einzelnen kristallinen Bereichen. Er besteht im wesentlichen aus Titanoxid mit Anteilen von Barium, Strontium, Silizium und Kohlenstoff. Der Anteil von Barium und Strontium ist etwa um 50 % geringer als in der BST-Schicht 55. Im Gegensatz dazu konnten Silizium und Kohlenstoff in der BST-Schicht 55 nicht nachgewiesen werden.

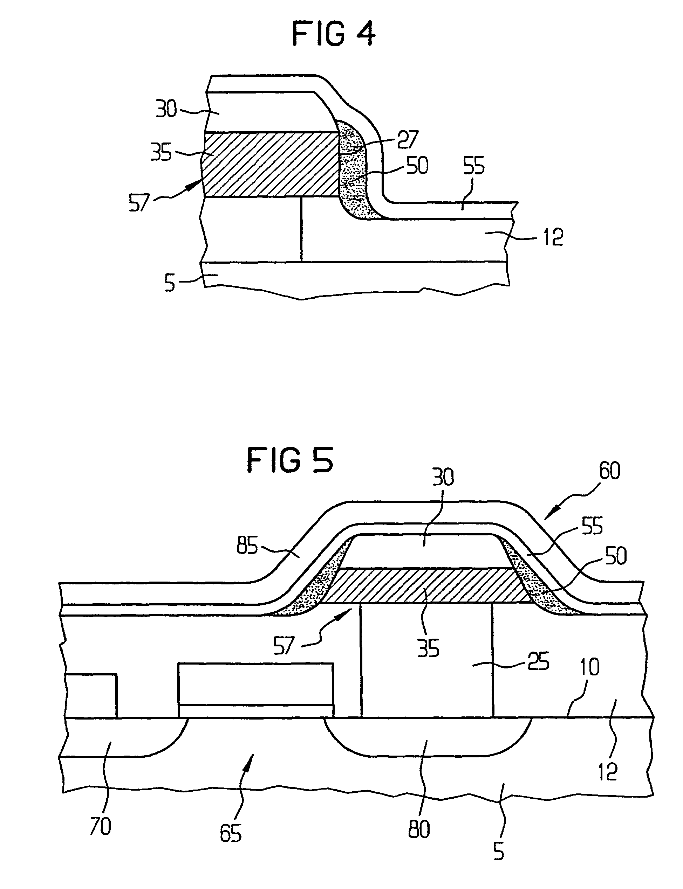

Figur 4 zeigt einen etwas vergrößerten Ausschnitt eines Randbereichs einer unteren Kondensatorelektrode 57. Diese umfaßt die Platinelektrode 30 sowie die Barriere 35. In diesem Ausführungsbeispiel ist die Barriere 35 dicker als die Platinelektrode 30 ausgelegt, so daß sich der Passivierungsrandsteg 50 über mehr als die Hälfte der unteren Kondensatorelektrode 57 erstreckt. Wichtig ist, daß die Randbereiche 27 der Barriere 35 vollständig von dem Passivierungsrandsteg 50 bedeckt sind.

Eine Speicherzelle einer Halbleiterspeichervorrichtung ist in Figur 5 dargestellt. Die Speicherzelle umfaßt einen Speicherkondensator 60 sowie einen Auswahltransistor 65. Dieser ist in einem Substrat 5 mit seinem Sourcegebiet 70 und seinem Draingebiet 80 integriert. Auf der Oberfläche 10 des Substrat 5 ist die TEOS-Schicht 12 aufgebracht. Auf dieser sitzt der Speicherkondensator 60 mit einer unteren Elektrode 57 bestehend aus einer Barriere 35 sowie einer Platinelektrode 30, mit einer BST-Schicht 55 sowie mit einer oberen Elektrode 85. Diese besteht ebenfalls bevorzugt aus Platin. Das Draingebiet 80 und die untere Elektrode 57 sind über ein mit Polysilizium gefülltes Kontaktloch 25 verbunden. Zur Verhinderung der Platindiffusion bzw. der Siliziumdiffusion ist das Polysilizium im Kontaktloch 25 von der Platinelektrode 30 durch die Barriere 35 getrennt. Seitlich der Barriere 35 ist ein in situ gebildeter selbstjustierter Passivierungsrandsteg 50 angeordnet. Dessen Materialstärke ist so eingestellt, daß einerseits eine ausreichende Passivierung der Barriere 35, d.h. eine Oxidationsbarriere, gewährleistet ist, andererseits jedoch kein zusätzlicher Raumbedarf für den Passivierungsrandsteg 50 besteht.

### Bezugszeichenliste

- 5: Substrat
- 10: Oberfläche des Substrats
- 12: Siliziumhaltige Oxidschicht / TEOS-Schicht
- 15: Barrierenschicht
- 20: Elektrodenschicht
- 25: Kontaktloch
- 27: Randbereich
- 30: Platinelektrode
- 35: Barriere
- 40: Materialablagerungen
- 50: Passivierungsrandsteg
- 55: BST-Schicht
- 57: Kondensatorelektrode
- 60: Speicherkondensator
- 65: Auswahltransistor
- 70: Sourcegebiet
- 80: Draingebiet
- 85: obere Elektrode

## Patentansprüche

1. Verfahren zur Herstellung eines Kondensators mit folgenden Schritten:
- Bereitstellen eines Substrats (5), mit einer siliziumhaltigen Oxidschicht oder einer Siliziumnitridschicht (12), einer drüber befindlichen Barrierenschicht (15, 35) sowie einer Elektrodenschicht (20, 30);
- bereichsweises Ätzen der Elektrodenschicht (20, 30) und der Barrierenschicht (15, 35) in einem gemeinsamen oder in nacheinanderfolgenden Ätzschritten zur Bildung wenigstens einer Elektrode (57) des Kondensators;
- CVD-Abscheidung wenigstens eines Metalls in einer oxidierenden Atmosphäre und bei einer Abscheidetemperatur zur Bildung einer, gegebenenfalls erst nach einem thermischen Ausheilschritt polykristallinen Metalloxidschicht (55),
**dadurch gekennzeichnet, daß**
die siliziumhaltige Oxidschicht oder die Siliziumnitridschicht (12) beim bereichsweisen Ätzen oder durch einen zusätzlichen Ätzschritt bis zu einem vorbestimmten Grad angegriffen wird, wobei Ätzreste der siliziumhaltigen Oxidschicht oder der Siliziumnitridschicht (12) zumindest im Randbereich (27) der Barrierenschicht (15, 35) verbleiben und dort während der CVD-Abscheidung der Metalloxidschicht (55) zusammen mit Bestandteilen der Metalloxidschicht (55) in situ einen im wesentlichen amorphen Passivierungsrandsteg (50) zwischen der Metalloxidschicht (55) und der Barrierenschicht (15, 35) bilden.

2. Verfahren nach Anspruch 1,
**dadurch gekennzeichnet,daß**
der Passivierungsrandsteg (50) siliziumhaltig ist und Anteile des abgeschiedenen Metalls enthält.

3. Verfahren nach Anspruch 1 oder 2,
**dadurch gekennzeichnet, daß**
die siliziumhaltige Oxidschicht (12) eine TEOS-Schicht (12) ist.

4. Verfahren nach einem der vorherigen Ansprüche,
**dadurch gekennzeichnet,daß**
die Elektrodenschicht (20, 30) und die Barrierenschicht (15, 35) mittels reaktivem Ionenätzen unter Anwesenheit von Chlor geätzt werden.

5. Verfahren nach einem der vorherigen Ansprüche,
**dadurch gekennzeichnet,daß**
die Abscheidetemperatur und der Grad des Angreifens der siliziumhaltigen Oxidschicht oder der Siliziumnitridschicht (12) während des Ätzens so aufeinander abgestimmt sind, daß der gebildete Passivierungsrandsteg (50) etwa doppelt so dick wie die Metalloxidschicht (55) ist.

6. Verfahren nach einem der vorherigen Ansprüche,
**dadurch gekennzeichnet, daß**
zur Abscheidung der Metalloxidschicht (55) ein Gemisch von Metall- und Erdalkalimetallkomplexen verwendet wird, die Beta-Diketonate enthalten.

7. Verfahren nach Anspruch 6,
**dadurch gekennzeichnet, daß**
die Metalloxidschicht (55) eine Barium-Strontium-Titanat-Schicht (BST) oder eine Strontium-Bismut-Tantalat-Schicht (SBT) (55) ist.

8. Verfahren nach Anspruch 6 oder 7,
**dadurch gekennzeichnet,daß**
die Abscheidetemperatur zwischen 400°C und 600°C liegt.

9. Verfahren nach Anspruch 7 oder 8,
**dadurch gekennzeichnet,daß**
im Falle einer Barium-Strontium-Titanat-Schicht (BST) der gebildete Passivierungsrandsteg (50) aus Titanoxid mit Anteilen von Silizium, Kohlenstoff, Barium und Strontium besteht, wobei der Anteil von Barium und Strontium im Passivierungsrandsteg (50) etwa halb so hoch wie in der Barium-Strontium-Titanat-Schicht (55) ist.

10. Verfahren nach Anspruch 7 oder 8,
**dadurch gekennzeichnet, daß**
im Falle einer Strontium-Bismut-Tantalat-Schicht (SBT) der gebildete Passivierungsrandsteg (50) aus Tantaloxid mit Anteilen von Silizium, Kohlenstoff, Bismut und Strontium besteht, wobei der Anteil von Bismut und Strontium im Passivierungsrandsteg (50) etwa halb so hoch wie in der Strontium-Bismut-Tantalat-Schicht (55) ist.

11. Verfahren nach einem der vorherigen Ansprüche,
**dadurch gekennzeichnet, daß**
nach der Abscheidung der Metalloxidschicht (55) zumindest eine weitere Elektrode (85) auf die Metalloxidschicht (55) aufgebracht wird.

## Claims

1. Method for fabricating a capacitor having the following steps:
- Provision of a substrate (5) with a silicon-containing oxide layer or a silicon nitride layer (12), a barrier layer (15, 35) situated thereabove and also an electrode layer (20, 30);
- region by region etching of the electrode layer (20, 30) and of the barrier layer (15, 35), in a common or in successive etching steps for the purpose of forming at least one electrode (57) of the capacitor;
- CVD deposition of at least one metal in an oxidizing atmosphere and at a deposition temperature for the purpose of forming a metal oxide layer (55), if appropriate one which is polycrystalline only after a thermal annealing step,
**characterized in that**
the silicon-containing oxide layer or the silicon nitride layer (12) is attacked to a predetermined degree during the region by region etching or by means of an additional etching step, etching residues of the silicon-containing oxide layer or of the silicon nitride layer (12) remaining at least in the edge region (27) of the barrier layer (15, 35) and forming there during the CVD deposition of the metal oxide layer (55) together with constituents of the metal oxide layer (55) in situ an essentially amorphous passivation edge web (50) between the metal oxide layer (55) and the barrier layer (15, 35).

2. Method according to Claim 1,
**characterized in that**
the passivation edge web (50) contains silicon and portions of the deposited metal.

3. Method according to Claim 1 or 2,
**characterized in that**
the silicon-containing oxide layer (12) is a TEOS layer (12).

4. Method according to one of the preceding claims,
**characterized in that**
the electrode layer (20, 30) and the barrier layer (15, 35) are etched by means of reactive ion etching in the presence of chlorine.

5. Method according to one of the preceding claims,
**characterized in that**
the deposition temperature and the degree to which the silicon-containing oxide layer or the silicon nitride layer (12) is attacked during the etching are co-ordinated with one another in such a way that the passivation edge web (50) formed is approximately twice as thick as the metal oxide layer (55).

6. Method according to one of the preceding claims,
**characterized in that**
a mixture of metal and alkaline earth metal complexes containing beta-diketonates is used for the deposition of the metal oxide layer (55).

7. Method according to Claim 6,
**characterized in that**
the metal oxide layer (55) is a barium strontium titanate layer (BST) or a strontium bismuth tantalate layer (SBT) (55).

8. Method according to Claim 6 or 7,
**characterized in that**
the deposition temperature lies between 400°C and 600°C.

9. Method according to Claim 7 or 8,
**characterized in that**,
in the case of a barium strontium titanate layer (BST), the passivation edge web (50) formed is composed of titanium oxide with proportions of silicon, carbon, barium and strontium, the proportion of barium and strontium in the passivation edge web (50) being approximately half as high as in the barium strontium titanate layer (55).

10. Method according to Claim 7 or 8,
**characterized in that**,
in the case of a strontium bismuth tantalate layer (SBT), the passivation edge web (50) formed is composed of tantalum oxide with proportions of silicon, carbon, barium, bismuth and strontium, the proportion of bismuth and strontium in the passivation edge web (50) being approximately half as high as in the strontium bismuth tantalate layer (55).

11. Method according to one of the preceding claims,
**characterized in that**
after the deposition of the metal oxide layer (55), at least one further electrode (85) is applied to the metal oxide layer (55).

## Revendications

1. Procédé de fabrication d'un condensateur comprenant des stades suivants :
- on se procure un substrat (5) ayant une couche d'oxyde contenant du silicium ou une couche (12) de nitrure de silicium, une couche (15, 35) barrière se trouvant au-dessus ainsi qu'une couche (20, 30) d'électrode ;
- on attaque par partie la couche (20, 30) d'électrode et la couche (15, 35) barrière dans un stade d'attaque commun ou dans des stades qui se succèdent pour former au moins une électrode (57) du condensateur ;
- on dépose par CVD au moins un métal dans une atmosphère oxydante et à une température de dépôt pour la formation d'une couche (55) d'oxyde métallique polycristalline, éventuellement seulement après un stade de recuit thermique,
**caractérisé en ce que**
on attaque la couche d'oxyde contenant du silicium ou la couche (12) de nitrure de silicium lors de l'attaque par partie ou par un stade d'attaque supplémentaire jusqu'à un degré déterminé à l'avance, des restes d'attaque de la couche d'oxyde contenant du silicium ou de la couche (12) de nitrure de silicium au moins dans la partie (27) de bord de la couche (15, 35) barrière formant, pendant le dépôt CVD de la couche (55) d'oxyde métallique ensemble avec des constituants de la couche (55) d'oxyde métallique, in situ une entretoise marginale sensiblement amorphe de passivation entre la couche (55) d'oxyde métallique et la couche (15, 35) barrière.

2. Procédé suivant la revendication 1,
**caractérisé en ce que**
l'entretoise (50) marginale de passivation contient du silicium et contient des proportions du métal déposé.

3. Procédé suivant la revendication 1 ou 2,
**caractérisé en ce que**
la couche (12) d'oxyde contenant du silicium est une couche (12) de TEOS.

4. Procédé suivant l'une des revendications précédentes,
**caractérisé en ce que**
la couche (20, 30) d'électrode et la couche (15, 35) barrière sont attaquées au moyen d'une attaque ionique réactive en la présence de chlore.

5. Procédé suivant l'une des revendications précédentes,
**caractérisé en ce que**
la température de dépôt et le degré d'attaque de la couche d'oxyde contenant du silicium ou de la couche (12) de nitrure de silicium sont, pendant l'attaque, adaptées l'une à l'autre de façon à ce que l'entretoise (50) marginale de passivation qui est formée soit à peu près deux fois plus épaisse que la couche (55) d'oxyde métallique.

6. Procédé suivant l'une des revendications précédentes,
**caractérisé en ce que**
pour le dépôt de la couche (55) d'oxyde métallique on utilise un mélange de complexes métalliques et de métal alcalino-terreux qui contient des béta-dicétonates.

7. Procédé suivant la revendication 6,
**caractérisé en ce que**
la couche (55) d'oxyde métallique est une couche de titanate de baryum et de strontium (BST) ou une couche de tantalate de strontium et de bismuth (SBT) (55).

8. Procédé suivant la revendication 6 ou 7,
**caractérisé en ce que**
la température de dépôt est comprise entre 400°C et 600°C.

9. Procédé suivant la revendication 7 ou 8,
**caractérisé en ce que**
dans le cas d'une couche de titanate de baryum et de strontium (BST), l'entretoise (50) marginale de passivation formée est en oxyde de titane ayant des proportions de silicium, de carbone, de baryum et de strontium, la proportion de baryum et de strontium dans l'entretoise (50) marginale de passivation étant à peu près deux fois plus grande que dans la couche (55) de titanate de baryum et de strontium.

10. Procédé suivant la revendication 7 ou 8,
**caractérisé en ce que**
dans le cas d'une couche de tantalate de strontium et de bismuth, l'entretoise (50) marginale de passivation formée est en oxyde de tantale ayant des proportions de silicium, de carbone, de bismuth et de strontium, la proportion de bismuth et de strontium dans l'entretoise (50) marginale de passivation étant à peu près deux fois plus grande que dans la couche (55) de tantalate de strontium et de bismuth.

11. Procédé suivant l'une des revendications précédentes,
**caractérisé en ce que**
après le dépôt de la couche (55) d'oxyde métallique on dépose au moins une autre électrode (85) sur la couche (55) d'oxyde métallique.
